# FASCICULE DE BREVET EUROPEEN

(11) **EP 3 465 648 B1**
(45) Date de publication et mention de la délivrance du brevet: **24.03.2021**
(21) Numéro de dépôt: 17732519.8
(22) Date de dépôt: 02.06.2017
(51) Int. Cl.: G08B 21/04

(54) **PROCEDE ET SYSTEME DE DETECTION DE PERSONNES AU SOL**
VERFAHREN UND SYSTEM ZUR ERKENNUNG VON PERSONEN AM BODEN
METHOD AND SYSTEM FOR DETECTING PEOPLE ON THE GROUND

(30) Priorité: 07.06.2016 FR 1655207
(43) Date de publication de la demande: 10.04.2019
(73) Titulaire: Bostik SA, 92700 Colombes (FR)
(72) Inventeur: HOLE, Stéphane, 75013 Paris (FR); OUSSAR, Yacine, 75013 Paris (FR); HAFFNER, Julien, 77420 Champs Sur Marne (FR)
(74) Mandataire: Plasseraud IP
(86) Numéro de dépôt international: PCT/FR2017/051401
(87) Numéro de publication internationale: WO 2017/212153

(56) Documents cités:
- WO-A1-2014/053719
- FR-A1- 2 956 137
- US-A- 4 827 763

## Description

La présente invention concerne la détection de personnes chutant ou gisant sur un sol instrumenté avec un ou plusieurs capteurs capacitifs.

### ARRIERE-PLAN

L'invention s'applique notamment aux bâtiments, médicalisés ou non, dédiés aux personnes âgées tels que par exemple les maisons de retraite. D'autres applications peuvent être envisagées, par exemple dans le domaine de la sécurité (dans les musées, les maisons individuelles, les lieux publics, etc.).

Un capteur capacitif comporte un certain nombre d'électrodes. La mesure porte souvent sur la quantité de charges électriques présente sur l'une ou l'autre des électrodes soumises à une tension électrique, la capacité étant le rapport de la quantité de charges à la tension. Une mesure d'impédance complexe, avec une tension sinusoïdale, est également envisageable. La capacité mesurée renseigne sur l'environnement électrique des électrodes. En particulier, lorsqu'une électrode additionnelle vient à proximité du capteur, le couplage diélectrique change, ce qui fait varier la capacité mesurée.

L'électrode additionnelle en question peut notamment être constituée par le corps, en général suffisamment conducteur de l'électricité, d'une personne qui se trouve sur le sol. WO 2014/053719 A1 décrit un exemple de capteur capacitif adapté à la détection de présence d'un objet et/ou d'un individu sur le sol, comprenant un ensemble d'électrodes de forme allongée intégrées dans la structure du sol.

Le couplage capacitif entre le corps d'une personne et la terre et les autres électrodes du capteur dépend, entre autres, de la posture de la personne. Pour effectuer une détection efficace de la chute d'une personne sur le sol, il faut distinguer, dans les mesures de capacité, les cas « normaux » (personnes debout, objets stationnés ou circulant sur le sol, etc.) et les cas de personnes allongées, justifiant une alerte. Les données brutes du ou des capteurs capacitifs ne donnent pas une information précise permettant directement cette distinction.

Un but de la présente invention et de proposer des traitements permettant d'obtenir une détection relativement fiable de la chute d'une personne sur le sol à partir de mesures capacitives sur des électrodes intégrées au sol.

### RESUME

Il est proposé un procédé de détection de personnes au sol selon la revendication 1 annexée.

Selon un agencement possible des électrodes, le premier espacement est compris entre 3 et 8 centimètres, tandis que le second espacement est compris entre 15 et 30 centimètres.

Dans une réalisation du procédé, plusieurs points de mesure sont positionnés dans plusieurs repères respectifs définis par des axes de mesure différents selon des coordonnées fournies par les capacités électriques mesurées pour les paires d'électrodes respectivement associées aux différents axes de mesure. Pour détecter si une personne git sur le sol, on fait intervenir plusieurs critères de détection qui sont fonction des positions des points de mesure dans les repères respectifs. Un des repères peut éventuellement être défini par des axes de mesure incluant au moins un axe de mesure associé à une paire d'électrodes constituée de deux fois la même électrode.

Il est possible de normaliser les écarts de capacité électrique pour fournir les coordonnées des points de mesure dans un repère. La normalisation de l'écart pour chaque axe de mesure est typiquement réalisée relativement à la capacité électrique de référence préalablement mesurée pour l'un des N axes de mesure. Elle peut consister à diviser les mesures de capacité électrique par le carré de la mesure de capacité électrique de référence préalablement mesurée pour cet axe de mesure, pour obtenir les coordonnées des points de mesure dans le repère.

Certains modes de réalisation du procédé comprennent la détermination d'une région de non-alerte dans le repère défini par les N axes de mesure. Cette région contient les points de mesure observés lorsqu'aucune personne ne git sur le sol. Le critère de détection comprend alors une évaluation de la position d'un point de mesure courant par rapport à la région de non-alerte qui a été déterminée.

La région de non-alerte peut être déterminée à l'aide d'un apprentissage effectué après intégration des électrodes dans le sol, permettant d'estimer le contour de la région dans le repère considéré. L'apprentissage comprend par exemple l'adjonction à la région de non-alerte de points de mesure dont la plus petite distance par rapport aux points de mesure précédemment ajoutés à la région de non-alerte n'excède pas α fois la distance moyenne entre les points de mesure précédemment ajoutés à la région de non-alerte (par exemple a = 3).

Selon une autre caractéristique, le positionnement du point de mesure dans le repère défini par N axes de mesure comporte la détermination d'un premier point de mesure puis l'application d'une transformation mathématique au premier point de mesure. Cette transformation mathématique est choisie de façon à déplacer la zone de non-alerte définie pour un local comportant le sol où les électrodes sont intégrées vers une zone de non-alerte définie pour un local de référence.

La transformation mathématique peut notamment comprendre une homothétie et/ou une rotation. Dans ce cas, le procédé comporte, pour chaque axe de mesure, une mesure préalable, alors que le sol est inoccupé, d'une capacité électrique de référence entre les deux électrodes de la paire associée audit axe de mesure, et l'homothétie et/ou la rotation est appliquée au premier point de mesure ayant, le long de chaque axe de mesure, une coordonnée fournie par un écart entre la capacité électrique mesurée pour la paire d'électrodes associée audit axe de mesure et la capacité électrique de référence préalablement mesurée pour ledit axe de mesure.

La transformation mathématique peut être déterminée à partir de mesures effectuées dans le local de référence et dans le local comportant le sol où les électrodes sont intégrées, à l'aide d'un objet-étalon posé sur le sol.

Un autre aspect de l'invention se rapporte à un système de détection de personnes au sol, comprenant au moins trois électrodes intégrées dans le sol, une unité d'alimentation des électrodes et de mesure de capacité électrique entre les électrodes, et un calculateur pour commander l'unité d'alimentation et de mesure et détecter si une personne git sur le sol. Le calculateur est configuré pour exécuter les étapes d'un procédé tel que défini précédemment.

### BREVE DESCRIPTION DES DESSINS

D'autres particularités et avantages de la présente invention apparaîtront dans la description ci-après d'exemples de réalisation non limitatifs, en référence aux dessins annexés, dans lesquels :
- la figure 1 est un schéma en vue de dessus d'une pièce dont le sol est instrumenté avec des capteurs capacitifs convenant pour un exemple de mise en œuvre de la présente invention ;
- la figure 2 est un schéma en coupe d'une partie du sol instrumenté ;
- la figure 3 est un graphique illustrant un principe de détection utilisable dans le cadre de l'invention ;
- la figure 4 est un organigramme montrant des étapes d'un mode de réalisation du procédé selon l'invention ;
- les figures 5 et 6 sont des graphiques représentant des mesures capacitives prises avec différentes paires de d'électrodes et permettant de lever certaines ambiguïtés dans des modes de réalisation de l'invention ;
- la figure 7 est un organigramme montrant des étapes d'un autre mode de réalisation du procédé selon l'invention ;
- la figure 8 est un graphique représentant des mesures capacitives prises avec des paires d'électrodes intégrées différemment dans le sol instrumenté ;
- la figure 9 est un graphique similaire à celui de la figure 8 mais prenant en compte une normalisation des mesures ; et
- les figures 10 et 11 sont des graphiques représentant des mesures capacitives avant et après application d'une transformation mathématique.

### DESCRIPTION DE MODES DE REALISATION

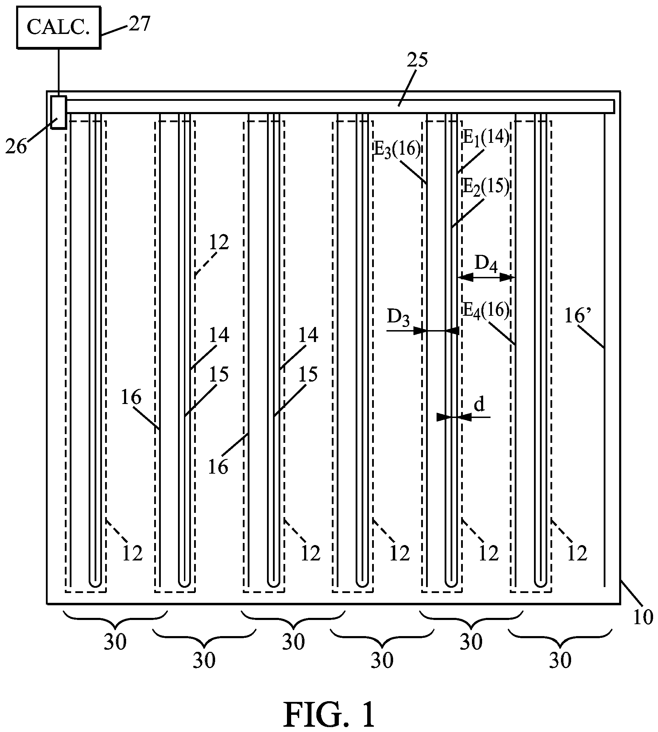

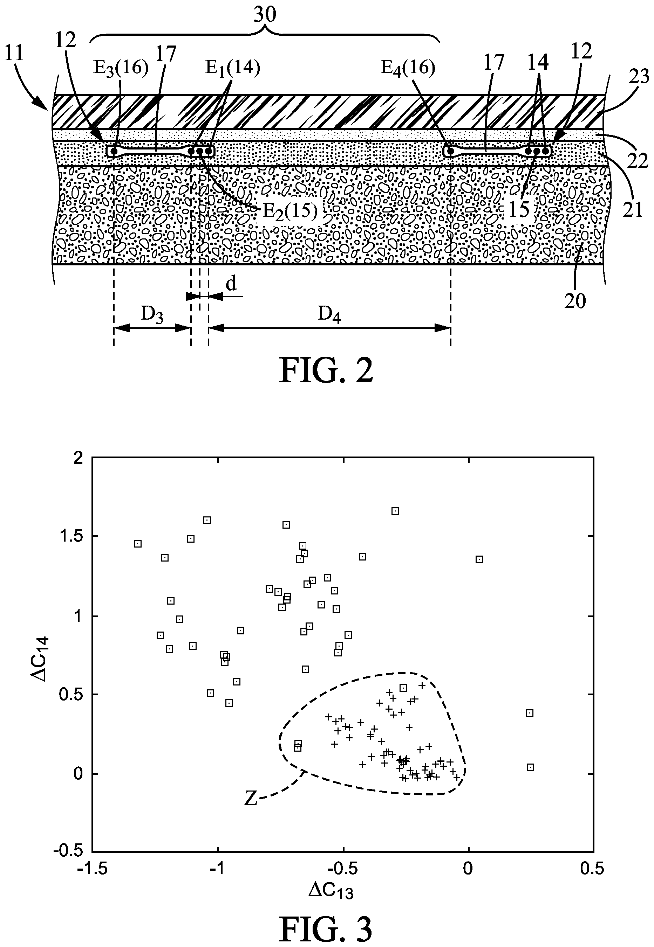

Le local 10 illustré à titre d'exemple sur les figures 1 et 2 a un sol 11 instrumenté avec des capteurs capacitifs de type similaire à ceux décrits dans WO 2014/053719 A1.

Ces capteurs comprennent des électrodes de forme allongée, typiquement des fils métalliques, qui s'étendent parallèlement les unes aux autres.

Dans l'exemple représenté, les électrodes sont regroupées dans des bandes 12 disposées à l'intérieur de la structure du sol 11. Chaque bande 12 comprend trois électrodes 14, 15, 16 qui s'étendent parallèlement entre elles dans un même plan horizontal. Pour la commodité d'installation et de maintien en place des électrodes, la bande 12 peut comprendre un ruban en matière isolante 17 à l'intérieur duquel les électrodes 14-16 sont noyées. Dans cet exemple, chaque bande 12 inclut :
- une première électrode filaire 14 qui se compose de deux brins parallèles réunis en boucle à une extrémité de la bande ;
- une deuxième électrode filaire 15 qui s'étend à l'intérieur de la boucle formée par la première électrode 14 ;
- une troisième électrode filaire 16 disposée à une distance D₃ la première électrode 14.

La distance d entre la deuxième électrode 15 et chaque brin de la première électrode 14 dans une bande 12 est nettement plus petite que la distance D₃ entre les première et troisième électrodes 14, 16.

Comme le montre la figure 2, les bandes 12 formant les capteurs capacitifs sont intégrées dans la structure du sol 11, par exemple dans une couche de ragréage 21 recouvrant une chape 20 et sur laquelle une couche de colle 22 sert à maintenir un revêtement de surface 23. Bien entendu, les bandes 12 peuvent être disposées dans l'une quelconque de ces couches 20-23, ou à l'une de leurs interfaces.

La figure 1 montre encore un bus de connexion 25 qui s'étend perpendiculairement aux bandes 12, par exemple le long de l'une des cloisons du local 10, dans la structure de sol 11 ou dans une plinthe. Le bus 25 a des conducteurs pour permettre la connexion individuelle et indépendante de chacune des électrodes des capteurs à une unité d'alimentation et de mesure 26 située dans le local 10 ou à proximité de celui-ci.

Un calculateur 27 est relié à l'unité d'alimentation et de mesure 26 pour traiter les mesures de capacité réalisées. Le calculateur 27, par exemple un microprocesseur, exécute des programmes adaptés à la mise en œuvre des traitements de mesures expliqués ci-après et au pilotage de l'unité d'alimentation et de mesure 26 pour qu'elle exécute les séquences de mesure requises.

Les bandes 12 sont disposées parallèlement les unes aux autres pour couvrir la zone du local 10 où il est souhaité de pouvoir détecter la chute d'une personne. On note D₄ la distance, perpendiculairement aux bandes, entre la première électrode 14 d'une bande 12 et la troisième électrode 16 de la bande adjacente.

Dans les exemples de mise en œuvre de l'invention décrits ci-après, il est constitué des unités de mesure 30 composées chacune de quatre électrodes E₁, E₂, E₃, E₄, à savoir :
- E₁: la première électrode 14 d'une bande 12 ;
- E₂: la deuxième électrode 15 de la même bande 12, séparée d'une distance d de l'électrode E₁ ;
- E₃: la troisième électrode 16 de la même bande 12, séparée d'une distance D₃ de l'électrode E₁ ;
- E₄: la troisième électrode 16 de la bande voisine, séparée d'une distance D₄ de l'électrode E₁.

Dans la suite du présent mémoire, on entend par « capteur capacitif », une unité de mesure 30 de ce type, et on note Cᵢⱼ une valeur de capacité électrique mesurée entre les électrodes i et j d'un tel capteur (1 ≤ i ≤ 4, 1 ≤ j ≤ 4). Lorsque i et j désignent la même électrode (i=j), la capacité électrique est mesurée entre l'électrode i et la masse, ou la terre ou un potentiel quelconque servant de référence pour les tensions considérées.

Pour le dimensionnement des capteurs, on peut typiquement avoir d de l'ordre de 1 à 3 mm, D₃ de l'ordre de 3 à 8 cm et D₄ de l'ordre de 15 à 30 cm, avec des électrodes s'étendant sur toute la largeur du local 10. Selon l'invention, l'espacement D₃ entre les électrodes E₁ et E₃ d'un capteur 30 soit au moins 3 fois plus grand que l'espacement D₄ entre les électrodes E₁ et E₄ du capteur. Comme le montre la figure 1, il peut éventuellement y avoir une électrode filaire unique 16' à une extrémité du local 10, pour former l'électrode E₄ du capteur 30 adjacent à cette extrémité.

Chaque capteur capacitif 30 ainsi constitué est capable de fournir plusieurs phases de mesure sous le contrôle de l'unité d'alimentation et de mesure 26 et du calculateur 27. On entend ici par « phase de mesure » une opération dans laquelle l'une des électrodes du capteur 30 est excitée en étant portée à un potentiel électrique donné, les autres électrodes du capteur sont mises à la masse et la charge électrique est mesurée sur l'une des électrodes, qui peut être l'électrode excitée ou une autre électrode du capteur 30.

Ainsi, dans une phase de mesure P_{¡j}, l'unité 26 met à la masse toutes les électrodes du capteur 30 via le bus 25, sauf l'électrode Eᵢ à laquelle est appliquée une tension de référence V_{ref} par rapport à la masse, et mesure la charge électrique Q apparaissant sur l'électrode Eⱼ du capteur. La capacité électrique Cᵢⱼ entre les électrodes Eᵢ et Eⱼ est alors : Cᵢⱼ = Q/V_{ref}. La présence d'un objet conducteur sur le sol au voisinage du capteur 30 modifie l'environnement des électrodes considérées, et donc l'état de charge Q, donnant lieu à un écart sur la valeur de capacité Cᵢⱼ.

Il est à noter que l'unité d'alimentation et de mesure 26 peut conduire simultanément plusieurs phases de mesure Pᵢⱼ (1 ≤ j ≤ 4) pour une électrode Eᵢ donnée recevant la tension de référence V_{ref}.

Lorsque i = j, la phase Pᵢᵢ permet de mesurer la capacité propre de l'électrode Eᵢ, qui est éventuellement influencée aussi par la présence d'un objet conducteur à proximité.

Les mesures de capacité électrique peuvent être rapportées à un état à vide du local 10. L'état « à vide » du local ne correspond pas nécessairement à une situation où le sol est libre de tout objet. Il est possible que certains objets destinés à se trouver à demeure sur le sol y soient présents dans l'état dit « à vide », notamment des éléments de mobilier fixe. Cependant, dans l'état à vide, il n'y a généralement aucune personne dans le local 10. Si on note C_{ij,0} la capacité de référence mesurée entre les électrodes Eᵢ et Eⱼ d'un capteur 30 dans le local à vide, une mesure ultérieure de la capacité électrique Cᵢⱼ peut y être rapportée en prenant en compte l'écart ΔCᵢⱼ = Cᵢⱼ - C_{ij,0} dans l'exploitation des mesures.

La figure 3 illustre des mesures qui ont été réalisées expérimentalement dans un local de test 10 avec des électrodes configurées de la manière décrite ci-dessus dans un cas particulier où d = 1,27 mm, D₃ = 5 cm et D₄ = 20 cm. Il a été demandé à des personnes de différentes corpulences de se tenir soit en position allongée soit dans une autre position (debout, assise, accroupie) sur le sol du local pour la réalisation de ces mesures. Sur le graphique, les points de mesure représentés par des carrés (□) concernent des mesures prises lorsque la personne était allongée, tandis que les points de mesure représentés par des croix (+) concernent des mesures prises lorsque la personne était dans une position non allongée.

Les mesures de capacité représentées sur la figure 3 correspondent aux phases de mesure P₁₃ et P₁₄ pour l'un des capteurs capacitifs 30. Au préalable, les capacités à vide C_{13,0} et C_{14,0} ont été mesurées, et le graphique montre les écarts ΔC₁₃ = C₁₃ - C_{13,0} et ΔC₁₄ = C₁₄ - C_{14,0} pour les différents les points de mesure. Les points de mesure sont alors positionnés dans un repère (P₁₃, P₁₄) ayant deux axes de mesure, l'un en abscisse pour la phase P₁₃, où sont indiquées les capacités relatives ΔC₁₃ = C₁₃ - C_{13,0}, et l'autre en ordonnée pour la phase P₁₄ où sont indiquées les capacités relatives ΔC₁₄ = C₁₄ - C_{14,0}. Le long des deux axes, les unités de la figure 3 sont arbitraires.

Chaque axe de mesure est donc associé à une paire d'électrodes, à savoir les électrodes E₁ et E₃ pour l'axe des abscisses et les électrodes E₁ et E₄ pour l'axe des ordonnées. Au cas particulier, ces deux paires ont l'électrode E₁ en commun, mais ce n'est pas obligatoirement le cas.

La figure 3 montre la tendance qu'ont les points de mesure à se rassembler dans une région Z lorsque la personne n'est pas allongée et de se trouver hors de cette région Z lorsque la personne est allongée sur le sol. La région Z du repère dans laquelle se trouvent les points de mesure en l'absence de personne allongée sur le sol est appelée ici région de non-alerte.

De façon générale, les points de mesure se trouvent plus éloignés de l'origine (0, 0) lorsque la personne est allongée sur le sol (□) que lorsqu'elle ne l'est pas (+).

Cette observation permet de fournir un critère pour distinguer les cas où une personne a chuté et git sur le sol des cas où la personne (ou une autre) circule simplement dans le local ou y stationne sans être étendue sur le sol. Le critère repose sur la localisation de la région Z contenant des points de mesure qui seront à filtrer pour éviter des fausses détections de personnes allongées sur le sol.

La figure 3 montre que la région de non-alerte Z peut être déterminée de manière relativement fiable par une série de mesures faites dans un local donné 10 avec des personnes dont la posture est connue. La région Z peut alors être identifiée dans le repère (P₁₃, P₁₄) associé aux deux phases de mesure considérées, par exemple comme il a été fait en traçant le trait interrompu sur la figure 3.

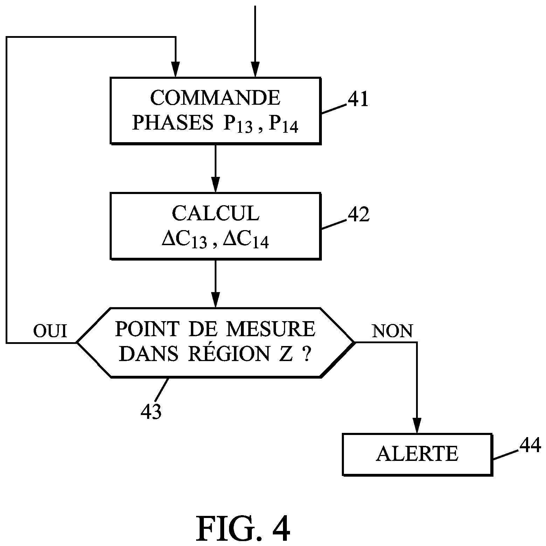

Une fois le critère ainsi défini, le procédé de détection peut se dérouler, par exemple de la manière représentée sur la figure 4, sous le contrôle du calculateur 27.

L'unité d'alimentation et de mesure 26 est commandée par le calculateur 27 pour exécuter périodiquement les phases de mesure P₁₃ et P₁₄ (étape 41), et récupérer ainsi les deux valeurs de capacité C₁₃ et C₁₄. À l'étape 42, le point de mesure correspondant est positionné dans le repère (P₁₃, P₁₄), en calculant les écarts ΔC₁₃ = C₁₃ - C_{13,0} et ΔC₁₄ = C₁₄ - C_{14,0}. Ensuite (étape 43), le calculateur 27 évalue si le point de mesure ainsi positionné se trouve dans la région de non-alerte Z. Si ce n'est pas le cas, une alerte est déclenchée à l'étape 44 pour que la personne qui gît vraisemblablement sur le sol puisse recevoir une assistance. Si le point de mesure est dans la région Z, il n'y a pas d'alerte et le processus revient à la surveillance périodique 41.

Même si la région de non-alerte Z est relativement bien définie sur la figure 3, il peut subsister des cas ambigus (symbole '□' dans la région Z ou à proximité). Il est souhaitable de lever ces ambiguïtés afin d'éviter les détections manquées de personnes allongées et/ou les fausses alertes.

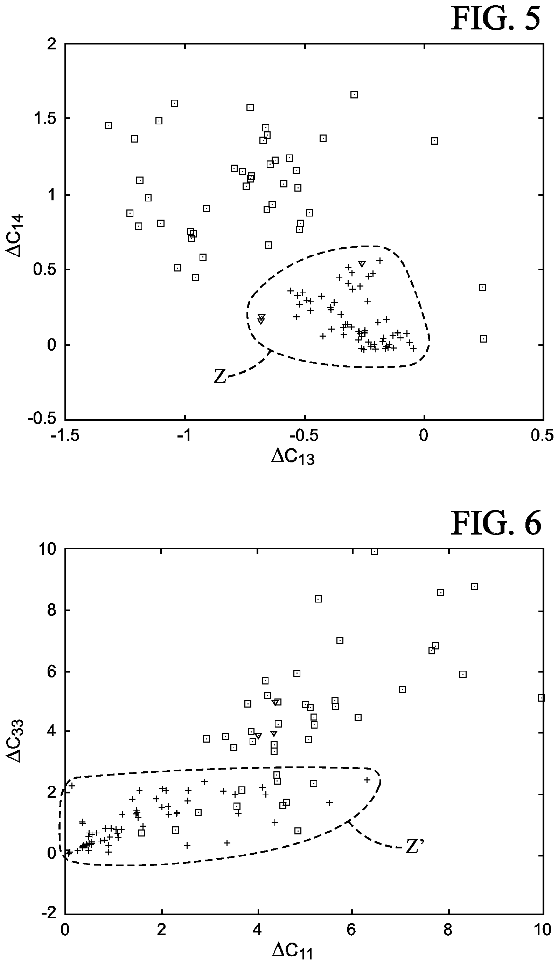

Une façon pour le faire est d'ajouter au critère de détection utilisant les phases P₁₃ et P₁₄, c'est-à-dire les paires d'électrodes (E₁, E₃) et (E₁, E₄), un autre critère de détection utilisant des paires d'électrodes différentes. C'est ce qu'illustrent les figures 5 et 6.

La figure 5 montre les mêmes points de mesure que la figure 3, avec cette différence que les cas ambigus sont représentés par des triangles ( 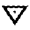 ). La figure 6 montre des points de mesure enregistrés sur les phases P₁₁ et P₃₃. Chaque fois qu'une personne s'est tenue allongée dans le local de test 10, des mesures des capacités C₁₃, C₁₄, C₁₁ et C₃₃ ont été enregistrées et les points de mesures correspondants ' 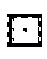 ' ont été positionnés dans les deux repères (P₁₃, P₁₄) et (P₁₁, P₁₃) des figures 5 et 6. De même, chaque fois qu'une personne s'est tenue dans une autre position dans le local de test 10, des mesures des capacités C₁₃, C₁₄, C₁₁ et C₃₃ ont été enregistrées et les points de mesures correspondants '+' ont été positionnés dans les deux repères (P₁₃, P₁₄) et (P₁₁, P₁₃) des figures 5 et 6. Les échantillons ambigus ' 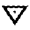 ' de la figure 5 ont été relevés dans des cas où les points de mesure dans le repère (P₁₁, P₁₃) de la figure 6 sont également notés par des triangles ( 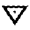 ).

Dans l'exemple de la figure 6, le repère est défini par des axes de mesure associés à des paires d'électrodes constituées chacune de deux fois la même électrode. Les capacités électriques considérées sont donc des capacités propres.

Sur la figure 6, on peut, comme précédemment, tracer une région de non-alerte Z' où se trouve la majorité des points de mesure correspondant à une personne non allongée. On voit que le couple de phases P₁₁, P₃₃ est un peu moins pertinent que le couple P₁₃, P₁₄ puisqu'il y a davantage de symboles ' 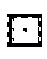 ' dans (ou à proximité de) la région Z' de la figure 6 que dans (ou à proximité de) la région Z de la figure 3. Cependant, il est intéressant d'observer que tous les échantillons ambigus ' 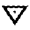 ' de la figure 5 ont leurs contreparties clairement en dehors de la région Z' de la figure 6.

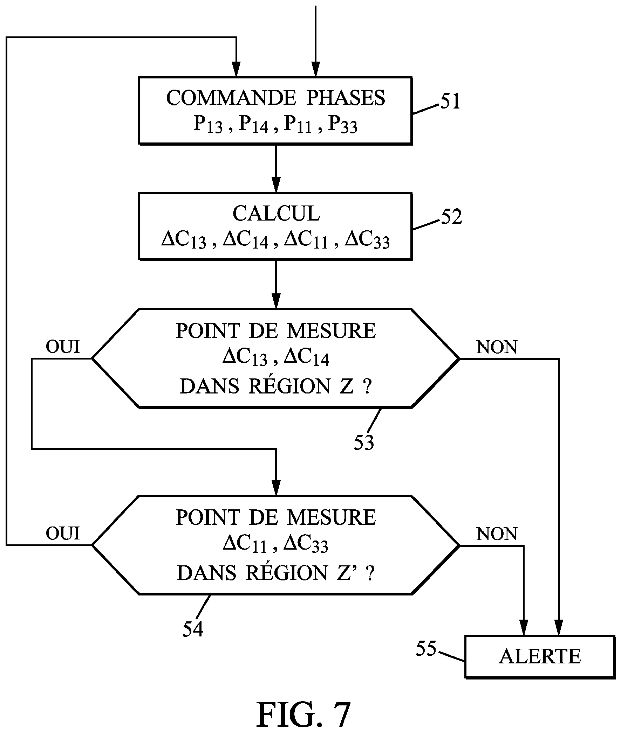

Cette observation permet d'affiner la décision personne allongée/non allongée. Le processus de détection peut alors être conforme à la figure 7.

Dans l'exemple de la figure 7, l'unité d'alimentation et de mesure 26 est commandée par le calculateur 27 pour exécuter périodiquement les phases de mesure P₁₃, P₁₄, P₁₁ et P₃₃ (étape 51), et récupérer ainsi les quatre valeurs de capacité C₁₃, C₁₄, C₁₁ et C₃₃. À l'étape 52, les points de mesure correspondants sont positionnés dans les repères (P₁₃, P₁₄) et (P₁₁, P₃₃), en calculant les écarts ΔC₁₃ = C₁₃ - C_{13,0}, ΔC₁₄ = C₁₄ - C_{14,0}, ΔC₁₁ = C₁₁ - C_{11,0} et ΔC₃₃ = C₃₃ - C_{33,0}. Ensuite (étape 53), le calculateur 27 évalue si le premier point de mesure dans le repère (P₁₃, P₁₄) se trouve dans la région de non-alerte Z. Si ce n'est pas le cas, une alerte est déclenchée à l'étape 55. Si le premier point de mesure est dans la région Z, un autre test 54 est effectué pour vérifier si le second point de mesure dans le repère (P₁₁, P₃₃) se trouve ou non dans la région de non-alerte Z'. Si ce n'est pas le cas, l'alerte est déclenchée à l'étape 55. Si le deux points de mesure sont dans les régions de non-alerte Z et Z', il n'y a pas lieu de déclencher une alerte et le processus revient à la surveillance périodique 51.

La multiplicité des paires d'électrodes combinables dans le système de capteurs capacitifs 30 permet d'affiner les critères de détection pour minimiser les occurrences de chutes non détectées et de fausses alertes. Une autre manière d'enrichir le critère de détection est de rechercher la région de non-alerte Z dans un espace à N dimensions avec N > 2. Ainsi, la région Z ne correspond plus seulement à une surface sur un graphique à deux dimensions tel que ceux des figures 3, 5 et 6, mais, par exemple, un volume dans un espace à N = 3 dimensions.

Selon la corpulence ou la taille de la personne, il peut y avoir des variations plus ou moins importantes du signal dans les phases de mesure prises en compte dans un repère donné. Cependant la région de non-alerte Z reste similaire dans un repère R donné pour les différentes personnes considérées.

Il peut en aller différemment en fonction de l'environnement dans lequel se trouve le ou les capteurs capacitifs, notamment la profondeur à laquelle se trouve les électrodes du ou des capteurs, ou selon la géométrie du ou des capteurs, notamment la longueur des électrodes. En général, plus les électrodes sont loin de la personne à détecter, plus les signaux sont faibles, de sorte que la région Z se contracte vers l'origine (0, 0) du repère R.

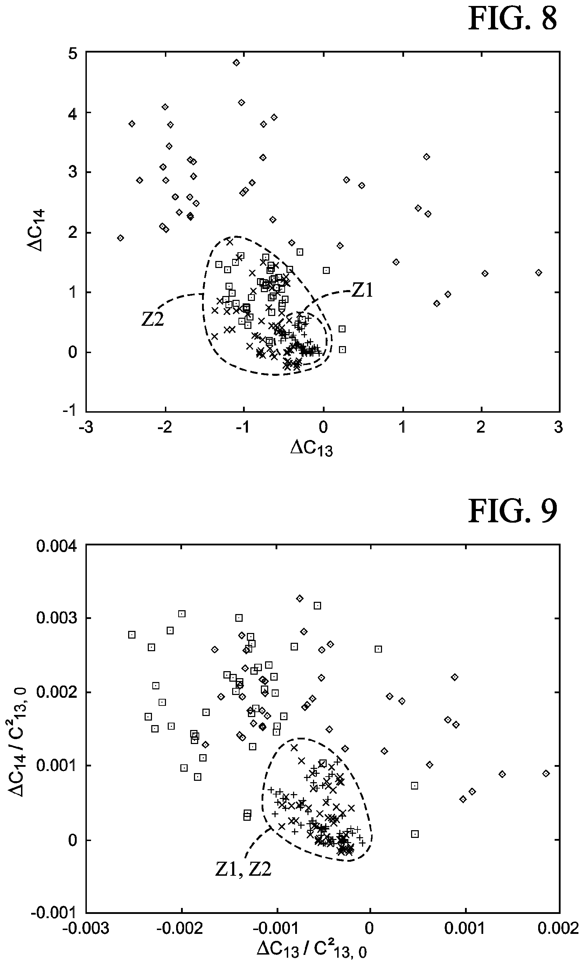

Ce phénomène est illustré par la figure 8 qui montre une nouvelle fois des points de mesure obtenus dans le repère associé aux paires d'électrodes (E₁, E₃) et (E₁, E₄). Les points de mesure notés ' 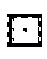 ' et '+' ont été relevés avec des personnes en positions allongée et non allongée, respectivement, alors que le local avait un premier type de revêtement de sol. Comme précédemment, il est possible de localiser une région de non-alerte Z1 où se rassemblent les points de mesure enregistrés avec une personne en position non allongée. Les points de mesure notés ' 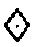 ' et '×' sur la figure 8 ont, de même, été relevés avec des personnes en positions allongée et non allongée, respectivement, alors que le local avait un autre type de revêtement de sol, moins épais. Là aussi, on peut localiser une région de non-alerte Z2 où se rassemblent les points de mesure enregistrés avec une personne en position non allongée. La région Z1 est moins étendue et plus proche de l'origine du repère que la région Z2.

Plusieurs moyens sont utilisables pour rendre la détection moins dépendante de la géométrie du local 10 où sont installés les capteurs ainsi que de la nature du sol et de son revêtement.

Par exemple et de manière non limitative, il est possible de normaliser les mesures entre elles, d'utiliser une mesure étalon pour appliquer une transformation dans le repère utilisé, de faire un apprentissage initial ou continu de la région de non-alerte après installation des capteurs dans un nouveau local.

La normalisation des mesures est une solution qui donne de bons résultats particulièrement lorsque le revêtement de sol varie. Elle consiste à normaliser les mesures de capacité électrique, pour fournir les coordonnées des points de mesure dans le repère, relativement à une mesure de capacité de référence entre les deux électrodes d'une paire associée à l'un des axes de mesure du repère à l'état à vide du sol. Cette normalisation intervient par exemple à l'étape 42 de la figure 4 ou à l'étape 52 de la figure 7.

La formule utilisée pour normaliser peut faire l'objet d'une optimisation en fonction de l'application considérée. Il a été constaté qu'une bonne méthode de normalisation consiste à calculer les coordonnées des points de mesure dans le repère (P₁₃, P₁₄) en procédant à une division par le carré du signal à vide de la phase P₁₃, c'est-à-dire à donner au point de mesure les coordonnées ΔC₁₃/(C_{13,0})² et ΔC₁₄/(C_{13,0})².

La figure 9 reprend les points de mesure de la figure 8 après normalisation sous cette forme. On voit que les régions Z1 et Z2 deviennent quasiment confondues. Ceci signifie que la normalisation a permis de s'affranchir des différences dues aux revêtements de sol.

L'utilisation d'un ou plusieurs objets-étalons permet de réaliser des mesures une fois le système installé dans un nouveau local 10 et de trouver une transformation permettant de déplacer le ou les points correspondant dans le repère considéré, par exemple (P₁₃, P₁₄). On peut ainsi ramener les points de mesure à une position dans le repère correspondant à un local de référence 10R.

La transformation calculée permet de transformer virtuellement le nouveau local 10 où sont installés les capteurs en un local de référence pour lequel la région de non-alerte Z est bien définie.

Une transformation appropriée consiste à appliquer une homothétie puis une rotation aux coordonnées du point de mesure dans le repère considéré.

On peut écrire mathématiquement cette transformation sous la forme XT = XN×XR/XE, où :
- le nombre complexe XN a ses parties réelle et imaginaire respectivement égales aux coordonnées d'un point de mesure obtenu dans le nouveau local 10 ;
- le nombre complexe XE a ses parties réelle et imaginaire respectivement égales aux coordonnées d'un point de mesure obtenu dans le nouveau local 10 avec l'objet-étalon (par exemple un seau d'eau) ;
- le nombre complexe XR a ses parties réelle et imaginaire respectivement égales aux coordonnées d'un point de mesure obtenu dans le local de référence 10R avec l'objet-étalon ;
- le nombre complexe XT a ses parties réelle et imaginaire respectivement égales aux coordonnées du point de mesure transformé.

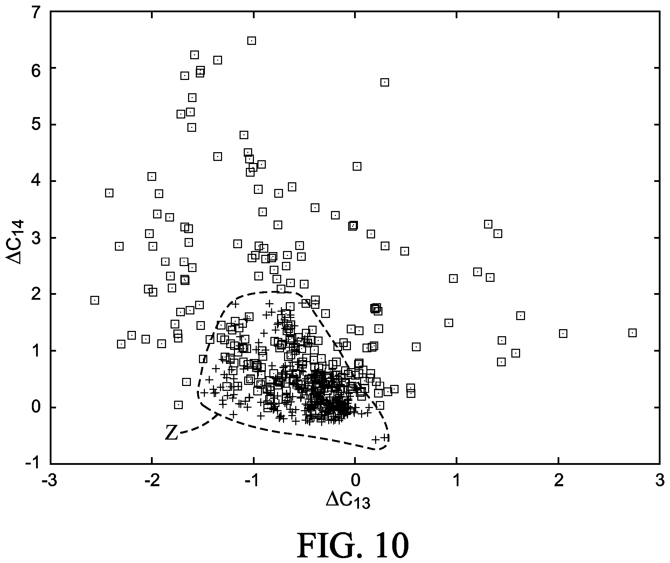

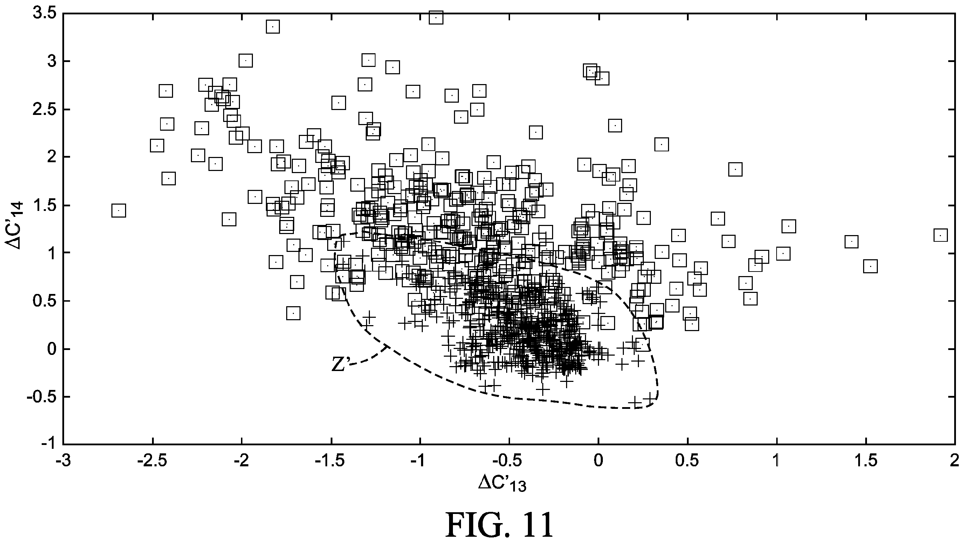

Un tel calcul peut être effectué à l'étape 42 de la figure 4 ou à l'étape 52 de la figure 7. D'autres formes de transformation sont également possibles dans la mesure où elles permettent de déplacer la région de non-alerte Z d'un nouveau local 10 (figure 10) vers une région de référence donnée Z' dans le repère considéré (figure 11).

Un apprentissage est une autre possibilité pour déterminer directement la région de non-alerte Z dans le repère considéré une fois le local équipé des capteurs capacitifs. Un apprentissage initial est relativement consommateur de temps puisqu'il nécessite d'effectuer un échantillonnage suffisamment abondant pour localiser précisément les contours de la région Z.

Une solution alternative est de réaliser apprentissage continu, c'est-à-dire que le calculateur 27 utilise les données mesurées en permanence pour déterminer et affiner les contours de la région de non-alerte Z.

Sachant que la région Z est relativement petite et correspond à des situations quotidiennes très fréquentes, les contours de cette région Z sont rapidement identifiés, la détection de la personne au sol correspondant alors au moment où le point de mesure dans le repère considéré s'écarte nettement des points déjà mesurés.

Dans un exemple non limitatif, la détection d'un écartement important consiste (i) à déterminer la plus petite distance, dans le repère considéré, entre le point de mesure courant et les différents points de mesure précédemment déterminés, (ii) à comparer cette plus petite distance à la distance moyenne entre les points déjà mesurés. Si la plus petite distance dépasse la distance moyenne multipliée par un facteur α (par exemple α = 3), alors le point de mesure est considéré hors de la région Z et une alerte est déclenchée. Sinon, il est considéré que le point de mesure se situe dans la région Z.

Un algorithme de détection de ce dernier type nécessite une phase pendant laquelle les personnes se trouvant dans le nouveau local 10 sont supposées ne pas être au sol de sorte qu'il y ait suffisamment de points de mesure échantillonnés pour dessiner un contour fiable de la région de non-alerte Z.

Un mode d'installation avantageux du système de détection comporte une initialisation de la région de non-alerte Z dans le repère choisi, par exemple (P₁₃, P₁₄), ou dans les repères choisis s'il y en a plusieurs, à l'aide de la technique de l'objet-étalon précédemment décrite, puis un apprentissage continu de la région Z comme il vient d'être mentionné. L'initialisation permet une opérabilité immédiate du système. En cas d'évolution du nouveau local du fait de son vieillissement ou de la pose de différents revêtements de sol, par exemple un tapis, le système s'adapte et reste opérationnel.

Les modes de réalisation décrits ci-dessus sont une simple illustration de la présente invention. Diverses modifications peuvent leur être apportées sans sortir du cadre de l'invention qui ressort des revendications annexées.

Un procédé de détection, tel que par exemple celui illustré par la figure 4 ou 7, peut être mis en œuvre pour chacun des capteurs capacitifs 30 représentés sur la figure 1 ou dans des configurations très diverses de tels capteurs. Il est également possible de croiser les mesures capacitives effectuées par des capteurs différents pour améliorer la prise de décision.

## Revendications

1. Procédé de détection de personnes au sol, dans lequel au moins trois électrodes (14-16) sont intégrées dans le sol (11), dans lequel des axes de mesure respectifs sont associés à plusieurs paires d'électrodes intégrées dans le sol, chaque axe de mesure représentant une fonction d'une capacité électrique entre les deux électrodes de la paire d'électrodes associée audit axe de mesure,
le procédé comprenant les étapes suivantes :
pour chaque paire d'électrodes, mesurer une capacité électrique entre les deux électrodes de la paire ;
positionner un point de mesure dans un repère défini par N des axes de mesure selon des coordonnées fournies par les capacités électriques mesurées pour les paires d'électrodes respectivement associées aux N axes de mesure, où N est un nombre plus grand que 1 ; et
détecter si une personne git sur le sol selon un critère de détection fonction de la position du point de mesure dans le repère ;
dans lequel pour un premier des N axes de mesure, les électrodes (E₁, E₃) de la paire associée sont sensiblement parallèles avec un premier espacement (D₃) entre elles, et pour un deuxième des N axes de mesure, les électrodes (E₁, E₄) de la paire associée sont sensiblement parallèles avec un second espacement (D₄) entre elles, et dans lequel les électrodes (E₁, E₃, E₄) des paires associées aux premier et deuxième axes de mesure sont situées dans un même plan horizontal ;
dans lequel le second espacement (D₄) étant au moins 3 fois plus grand que le premier espacement (D₃) ;
comprenant, pour chaque axe de mesure, une mesure préalable, alors que le sol (11) est inoccupé, d'une capacité électrique de référence entre les deux électrodes de la paire associée audit axe de mesure,
et dans lequel le point de mesure positionné dans le repère, le long d'un axe de mesure, une coordonnée fournie par un écart entre la capacité électrique mesurée pour la paire d'électrodes associée audit axe de mesure et la capacité électrique de référence préalablement mesurée pour ledit axe de mesure.

2. Procédé selon la revendication 1, dans lequel N = 2.

3. Procédé selon l'une quelconque des revendications précédentes, dans lequel plusieurs points de mesure sont positionnés dans plusieurs repères respectifs définis par des axes de mesure différents selon des coordonnées fournies par les capacités électriques mesurées pour les paires d'électrodes ((E₁, E₃), (E₁, E₄)) respectivement associées aux différents axes de mesure, et dans lequel détecter si une personne git sur le sol (11) est effectué selon plusieurs critères de détection qui sont fonction des positions des points de mesure dans les repères respectifs.

4. Procédé selon la revendication 3, dans lequel un des repères est défini par des axes de mesure incluant au moins un axe de mesure associé à une paire d'électrodes ((E₁, E₁), (E₃, E₃)) constituée de deux fois la même électrode.

5. Procédé selon l'une quelconque des revendications précédentes, dans lequel les écarts de capacité électrique sont normalisés pour fournir les coordonnées des points de mesure dans un repère, la normalisation de l'écart pour chaque axe de mesure étant relativement à la capacité électrique de référence (C_{13,0}) préalablement mesurée pour l'un des N axes de mesure.

6. Procédé selon l'une quelconque des revendications précédentes, comprenant une détermination d'une région de non-alerte (Z) dans ledit repère, la région de non-alerte contenant les points de mesure observés lorsqu'aucune personne ne git sur le sol.

7. Procédé selon la revendication la revendication 6, dans lequel la détermination de la région de non-alerte (Z) comprend un apprentissage effectué après intégration des électrodes (14-16) dans le sol (11) pour estimer un contour de la région de non-alerte (Z).

8. Procédé selon la revendication 7, dans lequel l'apprentissage comprend l'adjonction à la région de non-alerte (Z) de points de mesure dont la plus petite distance par rapport aux points de mesure précédemment ajoutés à la région de non-alerte (Z) n'excède pas α fois la distance moyenne entre les points de mesure précédemment ajoutés à la région de non-alerte (Z), où α est un coefficient prédéfini.

9. Procédé selon la revendication 8, dans lequel α = 3.

10. Procédé selon l'une quelconque des revendications 6 à 9, dans lequel le positionnement du point de mesure dans le repère défini par N axes de mesure comporte la détermination d'un premier point de mesure puis l'application d'une transformation mathématique au premier point de mesure, la transformation mathématique étant propre à déplacer la zone de non-alerte définie pour un local (10) comportant le sol où les électrodes (14-16) sont intégrées vers une zone de non-alerte définie pour un local de référence.

11. Procédé selon la revendication 10, comprenant, pour chaque axe de mesure, une mesure préalable, alors que le sol (11) est inoccupé, d'une capacité électrique de référence entre les deux électrodes de la paire associée audit axe de mesure,
et dans lequel la transformation mathématique comporte une homothétie et/ou une rotation appliquée au premier point de mesure ayant, le long de chaque axe de mesure, une coordonnée fournie par un écart entre la capacité électrique mesurée pour la paire d'électrodes associée audit axe de mesure et la capacité électrique de référence préalablement mesurée pour ledit axe de mesure.

12. Système de détection de personnes au sol, comprenant au moins trois électrodes (14-16) intégrées dans le sol (11), une unité (26) d'alimentation des électrodes et de mesure de capacité électrique entre les électrodes, et un calculateur (27) pour commander l'unité d'alimentation et de mesure (26) et détecter si une personne git sur le sol, le calculateur (27) étant configuré pour l'exécution des étapes suivantes :
pour chaque paire d'électrodes, mesurer une capacité électrique entre les deux électrodes de la paire ;
positionner un point de mesure dans un repère défini par N des axes de mesure selon des coordonnées fournies par les capacités électriques mesurées pour les paires d'électrodes respectivement associées aux N axes de mesure, où N est un nombre plus grand que 1 ; et
détecter si une personne git sur le sol selon un critère de détection fonction de la position du point de mesure dans le repère ;
dans lequel pour un premier des N axes de mesure, les électrodes (E₁, E₃) de la paire associée sont sensiblement parallèles avec un premier espacement (D₃) entre elles, et pour un deuxième des N axes de mesure, les électrodes (E₁, E₄) de la paire associée sont sensiblement parallèles avec un second espacement (D₄) entre elles, et dans lequel les électrodes (E₁, E₃, E₄) des paires associées aux premier et deuxième axes de mesure sont situées dans un même plan horizontal ;
dans lequel le second espacement (D₄) étant au moins 3 fois plus grand que le premier espacement (D₃) ;
comprenant, pour chaque axe de mesure, une mesure préalable, alors que le sol (11) est inoccupé, d'une capacité électrique de référence entre les deux électrodes de la paire associée audit axe de mesure,
et dans lequel le point de mesure positionné dans le repère, le long d'un axe de mesure, une coordonnée fournie par un écart entre la capacité électrique mesurée pour la paire d'électrodes associée audit axe de mesure et la capacité électrique de référence préalablement mesurée pour ledit axe de mesure.

## Patentansprüche

1. Verfahren zur Erfassung von Personen auf dem Boden, wobei mindestens drei Elektroden (14-16) in den Boden (11) eingebettet sind, wobei jeweilige Messachsen mehreren Paaren in den Boden eingebetteter Elektroden zugeordnet sind, wobei jede Messachse eine Funktion einer elektrischen Kapazität zwischen den beiden Elektroden des Elektrodenpaares darstellt, das der Messachse zugeordnet ist, wobei das Verfahren die folgenden Schritte umfasst:
- für jedes Elektrodenpaar, Messen einer elektrischen Kapazität zwischen den beiden Elektroden des Paares;
- Positionieren eines Messpunkts in einem durch N Messachsen definierten Bezugsbereich gemäß Koordinaten, die durch die gemessenen elektrischen Kapazitäten für die jeweils den N Messachsen zugeordneten Elektrodenpaare bereitgestellt werden, wobei N eine Zahl größer als 1 ist; und
- anhand eines Erfassungskriteriums in Abhängigkeit von der Position des Messpunkts in dem Bezugsbereich Erfassen, ob eine Person auf dem Boden liegt;
wobei für eine erste der N Messachsen die Elektroden (E₁, E₃) des zugehörigen Paares mit einem ersten Abstand (D₃) im Wesentlichen parallel sind, und für eine zweite der N Messachsen die Elektroden (E₁, E₄) des zugehörigen Paares mit einem zweiten Abstand (D₄) im Wesentlichen parallel sind, und wobei die Elektroden (E₁, E₃, E₄) der Paare, die der ersten und zweiten Messachse zugeordnet sind, in derselben horizontalen Ebene liegen;
wobei der zweite Abstand (D₄) mindestens dreimal größer als der erste Abstand (D₃) ist;
umfassend für jede Messachse eine vorherige Messung einer elektrischen Referenzkapazität zwischen den beiden Elektroden des der Messachse zugeordneten Paares, während der Boden (11) frei ist,
und wobei der Messpunkt in dem Bezugsbereich entlang einer Messachse positioniert ist, wobei eine Koordinate durch eine Abweichung zwischen der für das der Messachse zugeordnete Elektrodenpaar gemessenen elektrischen Kapazität und der zuvor für die Messachse gemessenen elektrischen Referenzkapazität bereitgestellt wird.

2. Verfahren nach Anspruch 1, wobei N = 2.

3. Verfahren nach einem der vorhergehenden Ansprüche, wobei mehrere Messpunkte in mehreren jeweiligen Bezugsbereichen, die durch verschiedene Messachsen definiert sind, gemäß Koordinaten positioniert werden, die durch die gemessenen elektrischen Kapazitäten für die Elektrodenpaare ((E₁, E₃), (E₁, E₄)), die jeweils den verschiedenen Messachsen zugeordnet sind, bereitgestellt werden, und wobei die Erkennung, ob eine Person auf dem Boden (11) liegt, gemäß mehrerer Erkennungskriterien durchgeführt wird, die eine Funktion der Positionen der Messpunkte in den jeweiligen Bezugsbereichen sind.

4. Verfahren nach Anspruch 3, wobei einer der Bezugsbereiche durch Messachsen definiert ist, die mindestens eine Messachse enthalten, die einem Elektrodenpaar ((E₁, E₁), (E₃, E₃)) zugeordnet ist, der aus zwei gleichen Elektroden besteht.

5. Verfahren nach einem der vorhergehenden Ansprüche, wobei die Abweichungen der elektrischen Kapazität normalisiert werden, um die Koordinaten der Messpunkte in einem Bezugsbereich bereitzustellen, wobei die Normalisierung der Abweichung für jede Messachse relativ zu der elektrischen Referenzkapazität (C_{13,0}) erfolgt, die zuvor für eine der N Messachsen gemessen wurde.

6. Verfahren nach einem der vorhergehenden Ansprüche, umfassend eine Bestimmung eines Nicht-Alarmbereichs (Z) in dem Bezugsbereich, wobei der Nicht-Alarm-bereich die Messpunkte enthält, die beobachtet werden, wenn keine Person auf dem Boden liegt.

7. Verfahren nach Anspruch 6, wobei die Bestimmung des Nichtalarmbereichs (Z) ein Training umfasst, das nach der Integration von Elektroden (14-16) im Boden (11) durchgeführt wird, um einen Umriss des Nichtalarmbereichs (Z) zu schätzen.

8. Verfahren nach Anspruch 7, wobei das Training das Hinzufügen von Messpunkten zu dem Nicht-Alarm-Bereich (Z) umfasst, deren kleinster Abstand zu den zuvor zu dem Nicht-Alarm-Bereich (Z) hinzugefügten Messpunkten das Mehrfache des mittleren Abstands zwischen den zuvor zu dem Nicht-Alarm-Bereich (Z) hinzugefügten Messpunkten nicht überschreitet, wobei α ein vordefinierter Koeffizient ist.

9. Verfahren nach Anspruch 8, wobei α = 3.

10. Verfahren nach einem der Ansprüche 6 bis 9, wobei die Positionierung des Messpunktes in dem durch N Messachsen definierten Bezugsbereich die Bestimmung eines ersten Messpunktes und die anschließende Anwendung einer mathematischen Transformation auf den ersten Messpunkt umfasst, wobei die mathematische Transformation dazu geeignet ist, den für einen Raum (10) mit dem Boden, in dem die Elektroden (14-16) integriert sind, definierten Nicht-Alarmbereich in einen für einen Referenzraum definierten Nicht-Alarmbereich zu verschieben.

11. Verfahren nach Anspruch 10, umfassend für jede Messachse eine vorherige Messung einer elektrischen Referenzkapazität zwischen den beiden Elektroden des der Messachse zugeordneten Paares, während der Boden (11) frei ist,
und wobei die mathematische Transformation eine angewendete Homothetie und/oder Drehung an einem ersten Messpunkt umfasst, der entlang jeder Messachse eine Koordinate aufweist, die durch eine Abweichung zwischen der gemessenen elektrischen Kapazität für das mit der Messachse verbundene Elektrodenpaar und der zuvor für die Messachse gemessenen elektrischen Referenzkapazität bereitgestellt wird.

12. System zur Erfassung von Personen auf dem Boden, mit mindestens drei in den Boden (11) eingebetteten Elektroden (14-16), einer Einheit (26) zum Versorgen der Elektroden mit Energie und zum Messen der elektrischen Kapazität zwischen den Elektroden, und einem Computer (27) zum Steuern der Versorgungs- und Messeinheit (26) und zum Erfassen, ob eine Person auf dem Boden liegt, wobei der Computer (27) derart konfiguriert ist, dass er die folgenden Schritte durchführt:
für jedes Elektrodenpaar, Messen einer elektrischen Kapazität zwischen den beiden Elektroden des Paares;
Positionieren eines Messpunktes in einem durch N der Messachsen definierten Bezugsbereich gemäß Koordinaten, die durch die gemessenen elektrischen Kapazitäten für die jeweils den N Messachsen zugeordneten Elektrodenpaare bereitgestellt werden, wobei N eine Zahl größer 1 ist; und
anhand eines Erfassungskriteriums in Abhängigkeit von der Position des Messpunkts in dem Bezugsbereich Erfassen, ob eine Person auf dem Boden liegt;
wobei für eine erste der N Messachsen die Elektroden (E₁, E₃) des zugehörigen Paares mit einem ersten Abstand (D₃) im Wesentlichen parallel sind, und für eine zweite der N Messachsen die Elektroden (E₁, E₄) des zugehörigen Paares mit einem zweiten Abstand (D₄) im Wesentlichen parallel sind, und wobei die Elektroden (E₁, E₃, E₄) der Paare, die der ersten und zweiten Messachse zugeordnet sind, in derselben horizontalen Ebene liegen;
wobei der zweite Abstand (D₄) mindestens 3 mal größer als der erste Abstand (D₃) ist;
umfassend für jede Messachse eine vorherige Messung einer elektrischen Referenzkapazität zwischen den beiden Elektroden des der Messachse zugeordneten Paares, während der Boden (11) frei ist,
und wobei der Messpunkt in dem Bezugsbereich entlang einer Messachse eine Koordinate positioniert ist, wobei eine Koordinate durch eine Abweichung zwischen der für das der Messachse zugeordnete Elektrodenpaar gemessenen elektrischen Kapazität und der zuvor für die Messachse gemessenen elektrischen Referenzkapazität bereitgestellt wird.

## Claims

1. Method for detecting people on a floor, wherein at least three electrodes (14-16) are integrated into the floor (11), wherein respective measurement axes are associated with multiple pairs of electrodes integrated into the floor, each measurement axis representing a function of a capacitance between the two electrodes of the pair of electrodes associated with said measurement axis,
the method comprising the following steps:
for each pair of electrodes, measuring a capacitance between the two electrodes of the pair;
positioning a measurement point in a coordinate system defined by N of the measurement axes at coordinates provided by the capacitances measured for the pairs of electrodes respectively associated with the N measurement axes, where N is a number greater than 1; and
detecting whether a person is lying on the floor according to a detection criterion function of the position of the measurement point in the coordinate system.
wherein for a first of the N measurement axes, the electrodes (E₁, E₃) of the associated pair are substantially parallel with a first spacing (D₃) between them, and for a second of the N measurement axes, the electrodes (E₁, E₄) of the associated pair are substantially parallel with a second spacing (D₄) between them, and wherein the electrodes (E₁, E₃, E₄) of the pairs associated with the first and second measurement axes are located in the same horizontal plane;
wherein the second spacing (D₄) is at least three times larger than the first spacing (D₃); comprising, for each measurement axis, a preliminary measurement, while the floor (11) is unoccupied, of a reference capacitance between the two electrodes of the pair associated with said measurement axis,
and wherein the measurement point positioned in the coordinate system has a coordinate, along a measurement axis, provided by a difference between the capacitance measured for the pair of electrodes associated with said measurement axis and the reference capacitance previously measured for said measurement axis.

2. Method according to claim 1, wherein N = 2.

3. Method according to any one of the preceding claims, wherein a plurality of measurement points are positioned in a plurality of respective coordinate systems defined by different measurement axes at coordinates provided by the capacitances measured for the pairs of electrodes ((E₁, E₃), (E₁, E₄)) respectively associated with the different measurement axes, and wherein the detecting whether a person is lying on the floor (11) is performed according to several detection criteria which are function of the positions of the measurement points in the respective coordinate systems.

4. Method according to claim 3, wherein one of the coordinate systems is defined by measurement axes including at least one measurement axis associated with a pair of electrodes ((E₁, E₁), (E₃, E₃)) consisting of the same electrode twice.

5. Method according to any one of the preceding claims, wherein the differences in capacitance are normalized in order to provide the coordinates of the measurement points in a coordinate system, the difference for each measurement axis being normalized relative to the reference capacitance (C_{13,0}) previously measured for one of the N measurement axes.

6. Method according to any one of the preceding claims, comprising a determination of a non-alert region (Z) in said coordinate system, the non-alert region containing the measurement points observed when no one is lying on the floor.

7. Method according to claim 6, wherein the determination of the non-alert region (Z) comprises a learning process carried out after integration of the electrodes (14-16) into the floor (11), in order to estimate a contour of the non-alert region (Z).

8. Method according to claim 7, wherein the learning process comprises the addition, to the non-alert region (Z), of measurement points for which the smallest distance to the measurement points previously added to the non-alert region (Z) does not exceed α times the average distance between the measurement points previously added to the non-alert region (Z), where α is a predefined coefficient.

9. Method according to claim 8, wherein α = 3.

10. Method according to any one of claims 6 to 9, wherein the positioning of the measurement point in the coordinate system defined by N measurement axes comprises determining a first measurement point and then applying a mathematical transformation to the first measurement point, the mathematical transformation being able to move the non-alert region defined for a room (10) containing the floor where the electrodes (14-16) are integrated, to a non-alert region defined for a reference room.

11. Method according to claim 10, comprising, for each measurement axis, a preliminary measurement, while the floor (11) is unoccupied, of a reference capacitance between the two electrodes of the pair associated with said measurement axis,
and wherein the mathematical transformation comprises a homothety and/or a rotation applied to the first measurement point having, along each measurement axis, a coordinate provided by a difference between the measured capacitance for the pair of electrodes associated with said measurement axis and the reference capacitance previously measured for said measurement axis.

12. System for detecting people on a floor, comprising at least three electrodes (14-16) integrated into the floor (11), a unit (26) for powering the electrodes and measuring the capacitance between the electrodes, and a computer (27) for controlling the power and measurement unit (26) and detecting whether a person is lying on the floor, the computer (27) being configured to execute the following steps:
for each pair of electrodes, measuring a capacitance between the two electrodes of the pair;
positioning a measurement point in a coordinate system defined by N of the measurement axes at coordinates provided by the capacitances measured for the pairs of electrodes respectively associated with the N measurement axes, where N is a number greater than 1; and
detecting whether a person is lying on the floor according to a detection criterion function of the position of the measurement point in the coordinate system;
wherein for a first of the N measurement axes, the electrodes (E₁, E₃) of the associated pair are substantially parallel with a first spacing (D₃) between them, and for a second of the N measurement axes, the electrodes (E₁, E₄) of the associated pair are substantially parallel with a second spacing (D₄) between them, and wherein the electrodes (E₁, E₃, E₄) of the pairs associated with the first and second measurement axes are located in the same horizontal plane;
wherein the second spacing (D₄) is at least three times larger than the first spacing (D₃);
comprising, for each measurement axis, a preliminary measurement, while the floor (11) is unoccupied, of a reference capacitance between the two electrodes of the pair associated with said measurement axis,
and wherein the measurement point positioned in the coordinate system has a coordinate, along a measurement axis, provided by a difference between the capacitance measured for the pair of electrodes associated with said measurement axis and the reference capacitance previously measured for said measurement axis.
